# EUROPÄISCHE PATENTSCHRIFT

(11) **EP 4 032 369 B1**
(45) Veröffentlichungstag und Bekanntmachung des Hinweises auf die Patenterteilung: **31.12.2025**
(21) Anmeldenummer: 20772285.1
(22) Anmeldetag: 15.09.2020
(51) Int. Cl.: H05B 3/26, B60S 1/48, F24H 9/18, H05B 3/82

(54) **PLATINE UND FLUIDHEIZER**
PRINTED CIRCUIT BOARD AND FLUID HEATER
CARTE DE CIRCUIT IMPRIMÉ ET DISPOSITIF DE CHAUFFAGE DE FLUIDE

(30) Priorität: 19.09.2019 DE 102019214314; 04.12.2019 DE 102019133043
(43) Veröffentlichungstag der Anmeldung: 27.07.2022
(73) Patentinhaber: DBK David + Baader GmbH, Nordring 26 76761 Rülzheim (DE)
(72) Erfinder: LOTHSCHÜTZ, Sebastian, 76848 Dimbach (DE); KRÄMER, Alexander, 76889 Schweigen-Rechtenbach (DE); FISCHER, Simon, 76137 Karlsruhe (DE)
(74) Vertreter: Winter, Brandl - Partnerschaft mbB
(86) Internationale Anmeldenummer: PCT/EP2020/075772
(87) Internationale Veröffentlichungsnummer: WO 2021/052964

(56) Entgegenhaltungen:
- WO-A1-01/67818
- WO-A1-2012/171072
- WO-A2-2004/078537
- DE-A1- 102018 106 354
- GB-A- 2 484 321

## Beschreibung

Die Erfindung betrifft eine Platine gemäß dem Oberbegriff des Patentanspruches 1 und einen mit einer derartigen Platine ausgeführten Fluidheizer.

Derartige Fluidheizer werden vorzugsweise zum Erwärmen von gasförmigen oder flüssigen Medien, beispielsweise Luft oder Wasser verwendet. Der Grundaufbau dieser Fluidheizer ist beispielsweise in der auf die Anmelderin zurückgehenden Druckschrift DE 10 2016 122 767 A1 erläutert. Dieser zur Erwärmung von Luft ausgeführte Fluidheizer hat ein als Rohrheizkörper ausgeführtes Heizelement, dessen Wärme über einen Wärmetauscher, auch Wärmeverteilelement genannt, auf das zu erwärmende Fluid übertragen wird. Bei dem konkret in der DE 10 2016 122 767 A1 beschriebenen Fluidheizer ist dieses Wärmeverteilelement als Metallschwamm oder Drahtgewebe/Drahtgeflecht ausgebildet, wobei die dadurch gebildeten Poren oder Kanäle von dem Fluid durchströmt werden. Selbstverständlich können auch andere Wärmeverteilelemente, beispielsweise Strangpressprofile oder Wellrippen zum Wärmeaustausch eingesetzt werden. Die Ansteuerung des Heizelementes erfolgt über eine Steuer- und Leistungselektronik, deren Schaltung auf einer Platine/Leiterplatte ausgebildet ist und die in einem Elektronikgehäuse angeordnet ist, das an ein das Heizelement und das Wärmeverteilelement aufnehmendes Gehäuse angesetzt ist. An diesem sind auch ein Zulauf und ein Ablauf für das zu erwärmende Fluid ausgebildet.

In der Druckschrift DE 10 2012 209 936 A1 ist ein Dickschichtheizer beschrieben, bei dem auf einem Substrat Leiterbahnen durch ein additives Verfahren aufgebracht sind. Diese Leiterbahnen bilden einen Heizwiderstand einer Heizeinrichtung aus.

In der ebenfalls auf die Anmelderin zurückgehenden DE 10 2018 106 354 A1 wird vorgeschlagen, auf der Platine angeordnete Leistungshalbleiter als Heizelemente zu verwenden, so dass die beim Betrieb der Leistungshalbleiter entstehende Wärme über ein Wärmeverteilelement auf das zu erwärmende Fluid übertragen wird.

Problematisch bei dieser Lösung ist, dass die über die Leistungshalbleiter erzeugte Wärme mit Bezug zur gesamten Wärmeaustauschfläche nur punktuell erzeugt wird, so dass ein erheblicher Aufwand erforderlich ist, um durch entsprechende Ausgestaltung des Wärmeverteilelementes eine flächige Wärmeübertragung zu ermöglichen. Zudem ist der vorrichtungstechnische Aufwand bei dieser Lösung erheblich, da die Verschaltung der im Wesentlichen zur Heizung verwendeten Leistungshalbleiter gegenüber den herkömmlichen Lösungen mit Rohrheizkörpern oder PTC-Heizelementen komplex und zudem aufgrund des vergleichsweise hohen Preises der Halbleiter auch teuer ist.

Demgegenüber liegt der Erfindung die Aufgabe zugrunde, die mit einer eine Steuer- oder Leistungselektronik ausbildenden Schaltung versehene Platine und einen damit ausgeführten Heizer derart weiterzubilden, dass ein effektives Heizen eines Fluids mit verringertem Aufwand, insbesondere verringertem schaltungstechnischen Aufwand ermöglicht ist.

Diese Aufgabe wird im Hinblick auf die Platine durch die Merkmalskombination des Patentanspruches 1 und im Hinblick auf den Heizer durch die Merkmale des nebengeordneten Patentanspruches 10 gelöst.

Vorteilhafte Weiterbildungen der Erfindung sind Gegenstand der Unteransprüche.

Die erfindungsgemäß ausgeführte Platine/Leiterplatte ist mit zumindest einem Heizstrang ausgeführt, der auf eine vorbestimmte Heizleistung zur Erwärmung eines Fluids ausgelegt ist. Dieser Heizstrang ist durch mittels eines subtraktiven Verfahrens, beispielsweise durch Ätzen geformte Leiterbahnen ausgebildet, deren Querschnitt, Länge und Material entsprechend des für die Heizleistung erforderlichen Heizwiderstandes ausgelegt ist. Das Material ist dementsprechend so ausgewählt, dass es mittels eines subtraktiven Verfahrens, beispielsweise durch Ätzen oder Fräsen, bearbeitbar ist.

Erfindungsgemäß ist somit die Platine/Leiterplatte zunächst mit einer aus dem Material der Leiterbahn ausgebildeten durchgängigen Schicht/Lage ausgeführt, von der dann durch Ätzen oder Fräsen die keine Leiterbahn ausbildenden Bereiche entfernt werden.

Eine derartige Lösung ermöglicht es, durch die geeignete Wahl des Querschnittes und der Geometrie des Heizstranges auf einfache Weise eine Anpassung an unterschiedliche Heizleistungen durchzuführen, wobei der schaltungstechnische Aufwand gegenüber der eingangs beschriebenen Lösung mit speziell zum Heizen ausgelegten Leistungshalbleitern erheblich verringert ist. Derartige Leistungshalbleiter sind erfindungsgemäß allenfalls zum Ansteuern bzw. Regeln des Heizkreises erforderlich. Erfindungsgemäß wird somit bei der Bestromung der Leiterbahn der parasitäre Nebeneffekt ausgenutzt, der daraus resultiert, dass sich die Leiterbahnabschnitte durch die Bestromung erwärmen.

Die Platine ist erfindungsgemäß mit einer Wärmeverteilschicht zur Wärmeübertragung auf das Fluid ausgeführt. Diese Wärmeverteilschicht kann beispielsweise als Formteil ausgeführt sein, das in den Schichtaufbau der Platine integriert ist und im Hinblick auf die Fluidführung und Wärmeübertragung optimiert ist. Durch die Integration der Wärmeverteilschicht in den Platinen-/Leiterplattenaufbau ist der vorrichtungstechnische Aufwand gegenüber herkömmlichen Lösungen verringert, bei denen ein gesondertes Wärmeverteilelement, beispielsweise Wärmeaustauschflächen oder dergleichen angesetzt werden müssen.

Die Platine wird vorzugsweise als IMS (Insulated Metal Substrate) - Leiterplatte ausgeführt, bei der bereits konzeptionell eine Wärmeverteilschicht integriert ist.

Ein weiterer wesentlicher Vorteil der erfindungsgemäßen Lösung ist, dass durch die geeignete Flächenerstreckung der Heizstränge/Leiterbahnen eine gleichmäßige Wärmeverteilung zum Erwärmen des Fluids gewährleistet ist.

Bei einem Ausführungsbeispiel der Erfindung ist zusätzlich zu dem Heizstrang auf der Platine/Leiterplatte eine Steuerschaltung und/oder eine Leistungselektronik ausgebildet, die beispielsweise zur Ansteuerung des Heizstrangs oder sonstiger elektronischer Bauelemente ausgebildet ist.

Gemäß einem bevorzugten Ausführungsbeispiel der Erfindung sind auf der Platine mehrere Heizstränge ausgebildet, die individuell ansteuerbar sind.

Jede IMS-Platine kann mehrlagig mit zumindest zwei Funktionslagen ausgeführt sein, in denen jeweils ein Heizelement und/oder die Steuerschaltung und/oder Leistungselektronik ausgebildet sein kann. Demgemäß kann eine Lage der IMS-Platine als Heizelement ausgeführt sein und eine andere Lage eine Steuerschaltung oder Leistungselektronik ausbilden. Selbstverständlich sind auch Mischformen realisierbar, bei denen eine Lage sowohl als Heizelement als auch im Sinne der Ansteuerung von Komponenten wirksam ist. Prinzipiell kann die IMS-Platine auch einlagig ausgeführt sein, wobei diese Lage sowohl die Funktion eines Heizelementes als auch einer Steuerschaltung/Leistungselektronik erfüllt.

Die Wärmeübertragung ist weiter verbessert, wenn der Heizstrang zumindest abschnittsweise durch mäanderförmig ausgebildete Leiterbahnen ausgeführt ist. Alternativ können die Leiterbahnen jedoch auch in Parallelanordnung oder dergleichen in Reihe und/oder parallel geschaltet sein.

Die Herstellung der Platine und deren Anschlusselemente ist besonders einfach, wenn letztere und sonstige Funktionselemente durch Umbiegen von Laschen oder Randabschnitten der IMS-Leiterplatte ausgebildet werden. So ist es beispielsweise möglich, einen Leiterbahnendabschnitt zu einem derartigen Randabschnitt zu führen und dann durch dessen Umbiegen eine Kontaktfahne oder dergleichen auszubilden.

Weiterhin ist es möglich, dass in dem umgebogenen Abschnitt zumindest ein Heizstrang ausgebildet ist, der über Abschnitte der Leiterbahn, die über die gebogenen Bereiche hinweg geführt sind, kontaktiert wird. Möglich ist es auch, zumindest einen Heizstrang abschnittsweise im umgebogenen Bereich verlaufen zu lassen.

Der erfindungsgemäße Heizer hat ein mit einer Platine der vorbeschriebenen Bauart ausgeführtes Heizelement.

Die Leiterbahn kann dabei mäanderförmig oder bifilar ausgeführt sein.

Besonders bevorzugt ist es, wenn die Platine einen von dem Fluid durchströmten Fluidkanal oder einen das Fluid aufnehmenden Fluidraum zumindest abschnittsweise begrenzt. D.h. bei einer derartigen Variante bildet die Platine einen Teil des Fluidkanals/Fluidraumes aus. Dieses Konzept, mit einem abschnittsweise von der Platine begrenzten Fluidraum ist Gegenstand einer parallel hinterlegten Patentanmeldung der Anmelderin.

Bevorzugte Ausführungsbeispiele der Erfindung werden im Folgenden anhand schematischer Zeichnungen näher erläutert. Es zeigen:
Figur 1 eine dreidimensionale Darstellung eines ersten Ausführungsbeispiels eines erfindungsgemäßen Fluidheizers;
Figur 2 den Fluidheizer gemäß Figur 1 mit abgenommenen Deckel;
Figur 3 eine Prinzipdarstellung einer IMS-Leiterplatte des Fluidheizers gemäß den Figuren 1 und 2;
Figur 4 eine Detaildarstellung der IMS-Leiterplatte gemäß Figur 3;
Figur 5 eine schematische Darstellung des Querschnittes einer derartigen IMS-Leiterplatte;
Figur 6 eine Darstellung zur Verdeutlichung der Geometrie zweier Heizstränge einer IMS-Leiterplatte gemäß den Figuren 4 und 5;
Figur 7 einen Schnitt entlang der Linie A-A in Figur 1 ;
Figur 8 einen entsprechenden Schnitt eines weiteren Ausführungsbeispiels eines Fluidheizers;
Figur 9 eine Einzeldarstellung eines Formteils zur Fluidführung in einem erfindungsgemäßen Heizer und
Figuren 10a, 10b stark schematisierte Darstellungen von Ausführungsbeispielen, bei denen die erfindungsgemäße Platine durch Umbiegen Anschlusselemente und/oder einen Fluidraum ausbildet.

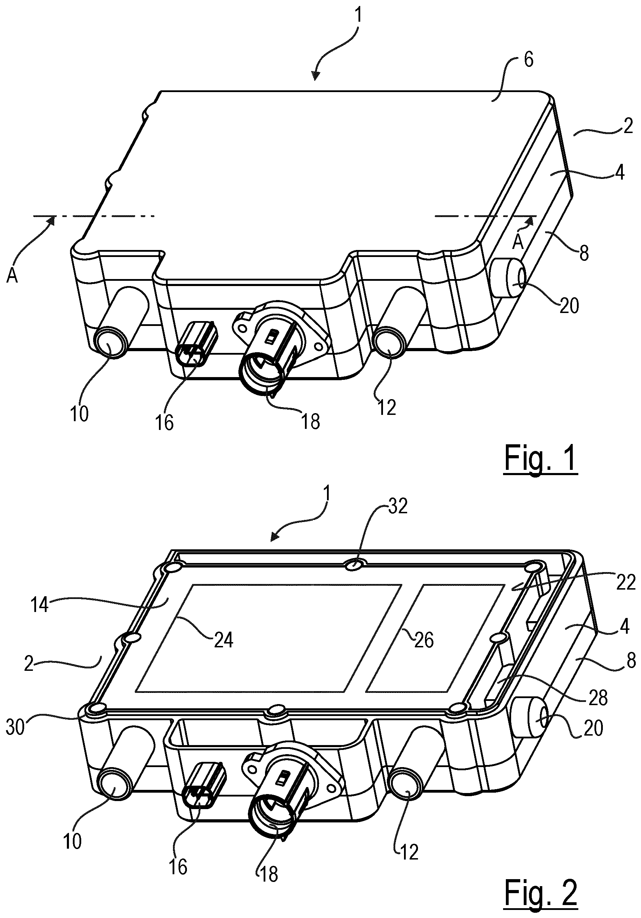

Figur 1 zeigt eine dreidimensionale Darstellung eines ersten Ausführungsbeispiels eines erfindungsgemäßen Fluidheizers 1, beispielsweise eines Hochvoltheizers, der beispielsweise zum Erwärmen von Wasser oder einer sonstigen Flüssigkeit genutzt wird. Der Fluidheizer 1 hat ein mehrteiliges Gehäuse 2 mit einem Mittelteil 4 und einem in der Ansicht gemäß Figur 1 oberen und unteren Deckel 6, 8. Dieses Gehäuse 2 begrenzt einen das zu erwärmende Fluid aufnehmenden Fluidraum, auf den in der Folge noch eingegangen wird. In diesem Fluidraum münden zwei Fluidanschlüsse 10, 12, wobei beispielsweise der Fluidanschluss 10 als Einlass und der Fluidanschluss 12 als Auslass ausgebildet sein kann. Beide Anschlüsse 10, 12 sind an ein das zu erwärmende Fluid führendes Leitungssystem angeschlossen. Beim dargestellten Ausführungsbeispiel sind die Fluidanschlüsse 10, 12 als Anschlussstutzen am Mittelteil 4 ausgebildet. Selbstverständlich können diese Anschlüsse auch deckelseitig vorgesehen werden.

Das erfindungsgemäße Gehäuse 2 nimmt des Weiteren noch zumindest eine Platine 14 (siehe Figur 2) auf, die mit zumindest einem Heizkreis zum Erwärmen des Fluids ausgeführt ist und zusätzliche elektronische Bauelemente zur Ansteuerung dieses Heizkreises und sonstiger Heizerkomponenten aufweisen kann. Zur Stromversorgung dieser Steuer- und/oder Leistungselektronik sowie der Elektronikkomponenten ist bei dem in Figur 1 dargestellten Ausführungsbeispiel am Mittelteil 4 ein Niedervoltstecker 16 und ein Hochvoltstecker 18 ausgebildet, wobei letzterer zur Hochvolt-Spannungsversorgung und der Niedervoltstecker auch zur Signalübertragung dient. Zur Kompensation von im Betrieb auftretenden Druckschwankungen einem die Steuer- und Leistungselektronik aufnehmenden Elektronikraum ist ein in Figur 1 mit dem Bezugszeichen 20 versehenes Druckausgleichselement vorgesehen. Die Gehäusekomponenten können beispielsweise im Hinblick auf eine EMV-Problematik aus geeignet beschichtetem Kunststoff oder aus einer geeigneten Metalllegierung hergestellt sein.

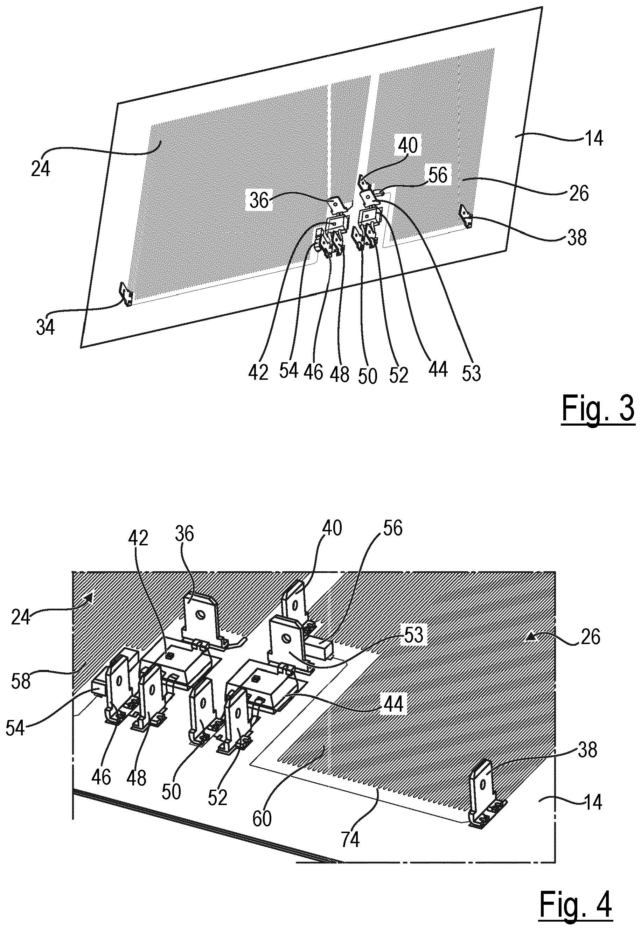

Figur 2 zeigt das Gehäuse 2 gemäß Figur 1, wobei der obere Deckel 6 abgenommen ist. Man erkennt dann den oben erwähnten Elektronikraum 22, in dem die Platine 14 angeordnet ist, durch die zum einen eine Steuer- und/oder Leistungselektronik und zum anderen die eigentliche Heizung des Fluidheizers 1 ausgebildet sein kann. Bei dem gezeigten Ausführungsbeispiel ist die Platine 14 mit zwei Heizkreisen 24, 26 ausgebildet, deren konkreter Aufbau später anhand der Figuren 3 bis 6 erläutert wird. Gemäß der Darstellung in Figur 2 füllt der Elektronikraum 22 nicht den gesamten Innenraum des Gehäuses 2 aus, sondern wird beispielsweise von einem bei diesem Ausführungsbeispiel etwa L-förmigen Außenraum 28 umgriffen, in dem weitere Komponenten des Fluidheizers, beispielsweise eine Verkabelung aufgenommen sein können.

Zwischen dem abgenommenen oberen Deckel 6 und der Platine 14 sowie zwischen dem unteren Deckel 8 und ggf. einer weiteren Platine oder der Platine 14 verbleibt jeweils ein in Figur 2 nicht sichtbarer Freiraum, in dem beispielsweise eine zusätzliche Steuerplatine oder sonstige Komponenten, wie beispielsweise ein Temperatursensor oder dergleichen aufgenommen sein können.

In an sich bekannter Weise sind an den in Figur 2 sichtbaren Stirnkanten des Mittelteils 4 Dichtkonturen 30 ausgebildet, die zur Lagefixierung einer Dichtung dienen. Entsprechende Konturen sind auch an dem oberen Deckel 6 und dem unteren Deckel 8 ausgebildet, so dass das Gehäuse 2 fluiddicht geschlossen werden kann. Die Verspannung des Mittelteils 4 mit den beiden Deckeln 6, 8 erfolgt über Schrauben, die in entsprechende Gewindebohrungen 32 des Mittelteils 4 eingeschraubt werden. Selbstverständlich kann anstelle einer derartigen Schraubverbindung das Gehäuse 2 auch stoffschlüssig verbunden werden.

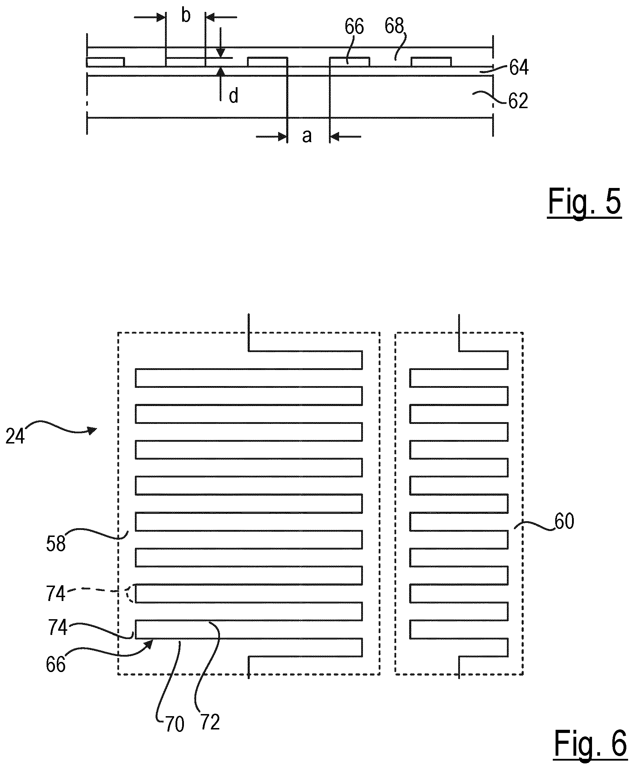

Figur 3 zeigt eine Einzeldarstellung der im Gehäuse 2 aufgenommenen Platine 14. Diese ist als IMS-Platine ausgeführt - der prinzipielle Aufbau derartiger IMS-Platinen 14 wird später anhand Figur 5 erläutert.

Beim dargestellten Ausführungsbeispiel (siehe auch Figur 4) ist die Platine 14 - wie oben erwähnt - mit den beiden Heizkreisen 24, 26 ausgebildet, wobei der Heizkreis 24 auf eine Heizleistung von beispielsweise 2 KW und der Heizkreis 26 auf eine Heizleistung von beispielsweise 1 KW ausgelegt ist. Die Spannungsversorgung der beiden Heizkreise 24, 26 erfolgt über aus der Platinenebene herausragende Anschlussfahnen 34, 36 (Heizkreis 24) bzw. 38, 40 (Heizkreis 26), wobei das Zu- und Abschalten der im Folgenden noch näher beschriebenen Heizstränge über Schaltelemente 42, 44 erfolgt, die beispielsweise als IGBT-Bausteine ausgeführt sind und Teil der durch die Platine 14 ausgebildeten Schaltung sind. Die Anschlüsse dieser Schaltelemente 42, 44 sind in der Darstellung gemäß Figur 3 mit den Bezugszeichen 46, 48, 50, 52, 53 versehen. Auf der Platine 14 sind gemäß Figur 3 noch weitere Elektronikbauteile 54, 56 der Steuer- und/oder Leistungselektronik ausgeführt. Prinzipiell kann in die durch die Platine 14 realisierte Schaltung auch ein Sensor zur Erfassung der Fluidtemperatur integriert sein.

Die beschriebenen Komponenten sitzen - wie vorstehend erläutert - auf der Platine 14, so dass deren Verlustleistung ebenfalls an das Fluid in Form von Wärme an das Fluid abgegeben wird. Eine derartige Lösung, bei der die elektronischen Bauelemente, beispielsweise Halbleiterbauelemente als Heizelemente ausgelegt sind, ist in der eingangs beschriebenen DE 10 2018 106 354 A1 erläutert. Im Unterschied zu dieser Lösung sind durch Leiterbahnen gebildeten Heizstränge der beiden Heizkreise 24, 26 im Hinblick auf die zu übertragende Heizleistung ausgelegt. Wie eingangs erläutert, ist die erfindungsgemäße Platine jedoch nicht auf ein Ausführungsbeispiel beschränkt, bei der die Leiterbahnen gemeinsam mit Steuerelementen und/oder einer Leistungselektronik vorgesehen sind - prinzipiell reicht es aus, wenn auf der Platine 14 lediglich ein durch zumindest eine Leiterbahn gebildeter Heizstrang ausgeführt ist, der im Hinblick auf das Aufheizen eines Fluids ausgelegt ist.

Figur 4 zeigt den mit den vorgenannten elektronischen Bauelementen belegten Bereich der Platine 14 aus Figur 3 in einer Detailansicht. Man erkennt in dieser Darstellung recht deutlich, dass bei diesem Ausführungsbeispiel die beiden Heizkreise 24, 26 - wie vorstehend erwähnt - durch aus Leiterbahnen gebildete Heizstränge 58, 60 realisiert sind, wobei die Leiterbahnen jeweils mäanderförmig auf der Platine 14 ausgebildet sind. Dies wird später anhand Figur 6 verdeutlicht.

Wie eingangs erwähnt, ist die Platine 14 als IMS-Platine ausgeführt. Diese hat gemäß Figur 5 in an sich bekannter Weise eine Wärmeverteilschicht 62, die üblicher Weise aus einem Metall, beispielsweise Aluminium oder Kupfer besteht und deren Schichtdicke zwischen 0,3 mm und 10 mm variieren kann. Als Standard hat sich eine Schichtdicke von etwa 1,5 mm durchgesetzt.

Auf dieser im Hinblick auf die optimale Wärmeübertragung auf das zu erwärmende Fluid ausgelegte Wärmeverteilschicht 62 ist eine integrierte Isolierschicht 64 aufgebracht, die typischer Weise eine Schichtstärke von 75 µm bis 200 µm aufweist und aus einem elektrisch gut isolierenden Material, vorzugsweise Kunststoff besteht. Auf dieser Isolierschicht 64 wird dann die den eigentlichen Heizstrang 58, 60 ausbildende Leiterbahn 66 aufgebracht. Diese besteht aus einem durch Ätzen oder Fräsen bearbeitbaren Material, wie beispielsweise aus Kupfer, Zink, Silber, Gold oder Nickel, wobei Kupfer bevorzugt ist.

Wie in der DE 10 2018 106 354 A1 erläutert, wird zunächst eine Leiterbahnschicht vollflächig aufgetragen und dann die im Folgenden noch näher erläuterte mäanderförmige oder bifilare Struktur der Heizstränge 58, 60 und die zu den vorgenannten Bauelementen/Schaltelementen führenden Leiterbahnabschnitte durch einen Ätzvorgang erzeugt, so dass sich die in den Figuren 4 und 6 angedeutete Heizstrangstruktur ergibt.

Zur elektrischen Isolierung und als Feuchtigkeitsschutz kann dann auf diese geätzte IMS-Leiterplatte 14 in einem weiteren Arbeitsschritt eine Isolierschicht, beispielsweise eine Schicht aus Lötstopplack 68 aufgetragen werden, die die Leiterbahnstruktur überdeckt. Dabei werden solche Bereiche ausgespart, auf die in einem folgenden Bestückungsarbeitsgang - beispielsweise im SMD-Verfahren - die oben genannten Schaltelemente 42, 44 und elektronischen Bauteilte 54, 56 aufgebracht werden. Nach dieser Bestückung gemäß einem Bestückungsplan erfolgt dann in einem vierten Arbeitsschritt die Ausbildung der Außenform der IMS-Platine 14 durch Stanzen, Fräsen und/oder Aussägen.

Die Struktur der Heizstränge 58, 60 ist im Hinblick auf die gewünschte Heizleistung ausgelegt. Dabei bestimmt sich der Heizwiderstand der beiden Heizstränge 58, 60 im Wesentlichen aus dem Material, der Länge und dem Querschnitt der beispielsweise mäanderförmig oder bifilar angeordneten Leiterbahnen 66. Dementsprechend wird die Leiterbahnbreite b und die Schichtdicke d der Leiterbahn 66 und deren Länge so gewählt, dass sich der für die vorbestimmte Heizleistung erforderliche Heizwiderstand ergibt. Dabei kann der Heizwiderstand auch durch Variation des Querschnittes (b, d) örtlich verändert werden. Durch diese lokale Variation des Heizwiderstandes können bewusst Hotspots generiert werden, die eine Art Sicherung ausbilden und bei einer übermäßigen Temperaturentwicklung oder Bestromung aufschmelzen. Ebenso können lokal Zonen mit weniger Leiterbahnen, somit geringerer Leistungsdichte erzeugt werden. Einen Einfluss auf die Leistungsdichte hat auch die Beabstandung a der einzelnen Leiterbahnen 66 der Mäanderstruktur.

Figur 6 zeigt den prinzipiellen Aufbau des mit einer größeren Heizleistung ausgeführten Heizkreises 24, der im Prinzip aus zwei Heizsträngen 58a, 58b besteht, die über die oben genannten Schaltelemente 42, 44 und elektronischen Bauteile 54, 56 individuell oder aber auch gemeinsam ansteuerbar sind. Wie erläutert, ist jeder Heizstrang 58a, 58b bei diesem Ausführungsbeispiel durch eine mäanderförmige Leiterbahn 66 ausgebildet, wobei jeweils längere Leiterbahnabschnitte 70, 72 über Umlenkungen 74 mit einander verbunden sind.

Selbstverständlich können, wie vorstehend erwähnt, anstelle der mäanderförmigen Struktur auch andere Strukturen, beispielsweise in Parallel- oder Serienschaltung angeordnete parallele Leiterbahnen, bifilare Strukturen oder Mischformen dieser Strukturen verwendet werden. Bei dem in Figur 6 dargestellten Ausführungsbeispiel sind die Umlenkungen 74 als quer zu den Leiterbahnabschnitten 70, 72 verlaufende gerade Elemente ausgeführt. Bei dem in Figur 4 gezeigten Ausführungsbeispiel sind die Umlenkungen 74 verrundet (siehe auch gestrichelte Linie in Figur 6).

Der einzelne Heizstrang 60 des zweiten Heizkreises 26 hat einen entsprechenden Aufbau, wobei die Heizleistung der einzelnen Heizstränge 58a, 58b und 60 beim dargestellten Ausführungsbeispiel entsprechend der gewünschten maximalen Heizleistung ausgelegt wird.

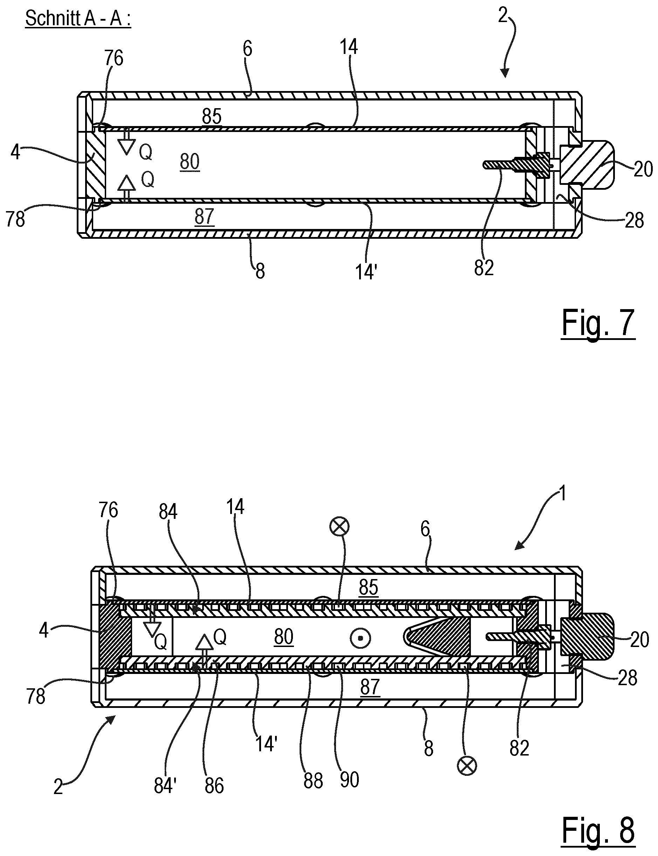

Figur 7 zeigt einen Schnitt entlang der Linie A-A in Figur 1. In dieser Schnittdarstellung sieht man Umfangswandungen des Mittelteils 4, auf die dichtend der obere Deckel 6 und der untere Deckel 8 aufgesetzt sind. Bei dem dargestellten Ausführungsbeispiel trägt das Mittelteil 4 eine gemäß den vorstehenden Ausführungen ausgebildete IMS-Platine 14, die mit zumindest einem Heizkreis ausgeführt ist und zusätzlich noch Komponenten der Steuer- und Leistungselektronik tragen kann. Diese Platine 14 ist in dem Bereich angeordnet, der von dem oberen Deckel 6 überstreckt wird.

In dem vom unteren Deckel 8 überstreckten Bereich ist eine weitere Platine 14' ausgebildet, die entsprechend der Platine 14 mit einem Heizkreis und/oder sonstigen Komponenten der Steuer- und/oder Leistungselektronik ausgeführt sein kann. Prinzipiell ist es auch möglich, die Platine 14 mit mehreren Heizkreisen als "Heizplatine" auszulegen, während die weitere Platine 14' die zur Steuerung und Regelung erforderlichen elektronischen Bauelemente, d.h. die Komponenten der Steuer- und Leistungselektronik aufnimmt, so dass jede Platine 14, 14' im Hinblick auf die jeweilige Funktion (Heizung - Steuerung, Regelung) optimiert ist. Die Platinen 14, 14' sind über geeignete Dichtelemente 76, 78 dichtend am Mittelteil 4 gehalten, so dass durch die Platinen 14, 14' und das Mittelteil 4 ein Fluidraum 80 ausgebildet wird, der von dem zu erwärmenden Fluid durchströmt wird oder in dem das zu erwärmende Fluid aufgenommen ist. Die erfindungsgemäßen Platinen 14, 14' begrenzen somit den Fluidraum 80 direkt. Dies ist ein wesentlicher Unterschied zu der Lösung gemäß der DE 10 2018 106 354 A1, bei der die Platine an die Umfangswandungen des Fluidraumes angesetzt wird, so dass kein direkter Wärmeeintrag von der Platine in das Fluid erfolgt.

Bei dem in Figur 7 dargestellten Ausführungsbeispiel ragt in den Fluidraum 80 der eingangs genannte Temperatursensor 82 hinein. Zu sehen ist auch das Druckausgleichselement 20, das in der Darstellung gemäß Figur 7 lediglich bespielhaft koaxial zur Achse des Temperatursensors 82 verläuft. Wie eingangs erläutert, wird durch dieses optionale Druckausgleichselement 20 sichergestellt, dass Druckschwankungen in den oberhalb bzw. unterhalb des Fluidraums 80 angeordneten Freiräumen 85, 87, die eine Art Elektronikraum bilden, ausgeglichen werden.

Die Anordnung der Platinen 14, 14' erfolgt derart, dass die vorbeschriebenen Wärmeverteilschichten 62 den Fluidraum abschnittsweise begrenzen, während die elektronischen Komponenten und die Heizstränge 58a, 58b, 60 mit den Leiterbahnen 66 zu den beiden Freiräumen 85, 87 hin weisend angeordnet sind. Wie vorstehend erwähnt, können in diesen Freiräumen 85, 87 weitere, hier nicht dargestellte Platinen oder sonstige Elemente der Steuer-/Leistungselektronik angeordnet sein.

In dem Schnitt gemäß Figur 7 sieht man auch einen Teil des anhand Figur 2 erläuterten Außenraums 28, in dem beispielsweise eine Verkabelung geführt sein kann und der mit den beiden Freiräumen 85, 87 verbunden ist. In dem Fall, in dem der Fluidraum 80 vom Fluid durchströmt wird, können im Bereich des Fluidraums 80 Fluidführungselemente 84 vorgesehen werden (siehe Figur 8).

Bei dem in Figur 7 dargestellten Ausführungsbeispiel ist der Fluidraum 80 mittig zwischen den beiden Platinen 14, 14' angeordnet. Prinzipiell ist es auch möglich, die Platinen 180° verdreht zu montieren, so dass die Wärmeverteilschichten 62 jeweils zum oberen Deckel 6 bzw. zum unteren Deckel 8 hin weisen und entsprechend dann mit dem jeweiligen Deckel 6, 8 zwei Fluidräume begrenzt werden, die mit einander in Fluidverbindung stehen. Bei einer derartigen, nicht dargestellten Variante sind dann die Komponenten der Steuer- oder Leistungselektronik und auch die Heizstränge 58a, 58b, 60 zu dem gemeinsamen mittleren Raum zwischen den Platinen 14, 14' hin weisend angeordnet. Dementsprechend müsste dann das Druckausgleichselement 20 in Wirkverbindung mit dem mittleren Raum stehen, während der Temperatursensor 82 zumindest in einem der von den Deckeln 6, 8 begrenzten Räumen angeordnet sein müsste.

Figur 8 zeigt eine Variante des Ausführungsbeispiels gemäß Figur 7, bei dem die beiden Platinen 14, 14' den mittleren Fluidraum 80 abschnittsweise begrenzen und die beiden Deckel 6, 8 mit den Platinen 14, 14' jeweils einen Freiraum 85, 87 ausbilden. Insofern entspricht das Ausführungsbeispiel gemäß Figur 8 demjenigen gemäß Figur 7. Im Unterschied zu Figur 7 ist bei dem Ausführungsbeispiel gemäß Figur 8 an die zum Fluidraum 80 weisenden Wärmeverteilschicht der Platinen 14, 14' jeweils ein Fluidführungselement 84, 84' angesetzt, das zum einen den Wärmeübergang von den vorbeschriebenen Heizsträngen 58a, 58b auf das Fluid verbessert und zum anderen zur Strömungsführung dient. Beim dargestellten Ausführungsbeispiel sind die Fluidführungselemente 84, 84' aus einem Material mit einer guten Wärmeleitung, beispielsweise aus Aluminium ausgeführt und werden direkt wärmeleitend an die Wärmeverteilschicht 62 der jeweiligen Platine 14, 14' angesetzt.

Das Fluidführungselement 84, 84' ist bei dem dargestellten Ausführungsbeispiel mit einer zum Fluidraum 80 hin weisenden durchgehenden Bodenplatte 86 ausgebildet, aus der heraus sich zur Platine 14, 14' hin Vorsprünge 88 erstrecken, so dass zwischen benachbarten Vorsprüngen das Fluid führende Kanäle 90 ausgebildet werden. Die Strömungsführung ist dabei so gewählt, dass beispielsweise der Zulauf zum Fluidheizer 1 in Fluidverbindung mit den Kanälen 90 steht, so dass die Strömung in den Kanälen 90 - wie in Figur 8 angedeutet - vom Betrachter weg erfolgt und dann über geeignete, nicht dargestellte Umlenkungselemente umgelenkt wird, so dass die Strömung im Fluidraum 80 zum Betrachter hin erfolgt. Selbstverständlich ist auch eine andere Strömungsführung realisierbar. Wie erläutert, wird die auf das Fluid zu übertragende Wärme Q in Pfeilrichtung von der Platine 14, 14' über das jeweilige Fluidführungselement 84, 84' auf das im Fluidraum 80 aufgenommene Fluid übertragen.

Wie bereits im Zusammenhang mit Figur 7 erläutert, können die Platinen 14, 14' auch um 180° verdreht eingebaut werden, so dass die Fluidführungselemente 84, 84' zum jeweiligen Freiraum 85 bzw. 87 hin weisend angeordnet sind und diese dann entsprechend Fluidräume ausbilden, während der mittige Raum 80 der Elektronikraum ist, der gegenüber dem Fluidräumen abgedichtet ist.

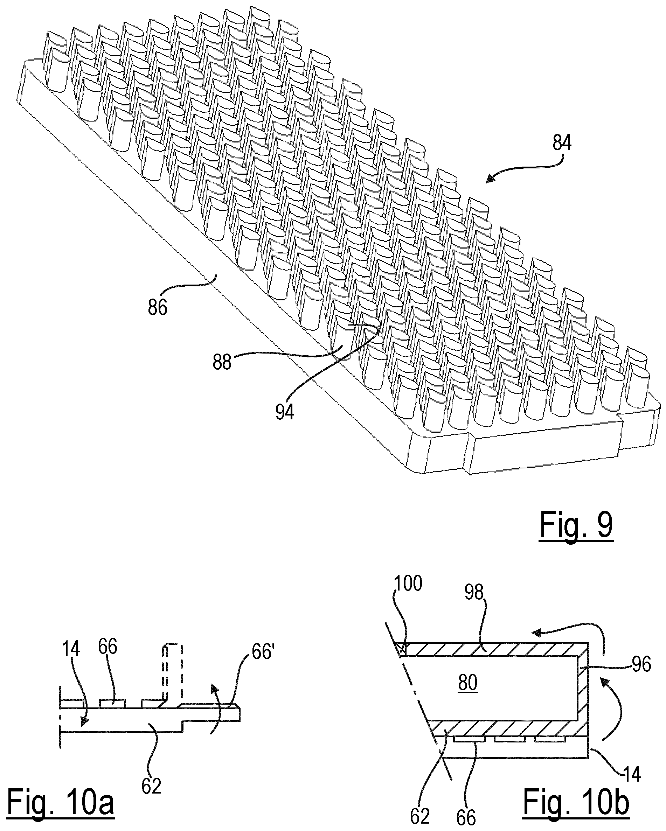

Figur 9 zeigt ein konkretes Ausführungsbeispiel eines Fluidführungselementes 84. Wie ausgeführt, hat dieses eine Bodenplatte 86, aus der heraus sich die Vorsprünge 88 erstrecken. Beim dargestellten Ausführungsbeispiel haben diese jeweils einen etwa tropfenförmigen, die Umströmung optimierenden Querschnitt 94. Das in Figur 9 dargestellte Fluidführungselement 84 ist aus einer Aluminiumlegierung, beispielsweise im Druckguss- oder Fließpressverfahren hergestellt.

Wie vorstehend erläutert, liegen die Vorsprünge 88 mit ihren tropfenförmigen Stirnflächen auf der Wärmeverteilschicht 62 der jeweiligen Platine 14, 14' auf, wobei vorzugsweise eine dichtende Anlage gewählt wird, so dass eine definierte Strömung innerhalb der Kanäle 90 gewährleistet ist. Eine gewisse Undichtigkeit ist im Prinzip jedoch unproblematisch. Auch bei diesem Ausführungsbeispiel erfolgt die Abdichtung des Fluidraums 80 gegenüber den Freiräumen 85, 87 und dem Außenraum 28 durch geeignete Dichtelemente 76, 78.

Wie ausgeführt, besteht eine erfindungsgemäße Besonderheit darin, dass zum einen die Platinen 14, vorzugsweise IMS-Platinen 14, 14' als Heizelemente ausgeführt sind und zum anderen einen Teil eines das erwärmende Fluid aufnehmenden Fluidraums begrenzen. Anhand der Figuren 10a, 10b werden Weiterbildungen dieses Konzeptes erläutert.

Figur 10a zeigt eine Variante, bei der in Randbereichen einer Platine 14 die Wärmeverteilschicht 62 etwas zurückgestuft ist, so dass dieser zurückgestufte Bereich, wie in Figur 10a gestrichelt angedeutet, zur Ausbildung von Anschlussfahnen oder sonstigen Funktionselementen nach oben in Richtung der die Leiterbahn 66 aufnehmenden Seite aufgebogen werden kann. Dieses Umbiegen erfolgt vorzugsweise partiell lediglich in denjenigen Bereichen, in denen derartige Funktionselemente, beispielsweise Anschlussfahnen ausgebildet sein müssen. Im letztgenannten Fall kann sich ein Leiterbahnendabschnitt 66' bis in den freigeschnittenen oder entsprechend der auszubildenden Anschlussfahne begrenzten Bereich hinein erstrecken, der in einem folgenden Arbeitsgang zur Anschlussfahne umgebogen wird.

Bei einer Weiterbildung der Erfindung kann auch ein Heizstrang vollständig oder abschnittsweise in dem umgebogenen Bereich ausgebildet sein, wobei dann die Kontaktierung vorzugsweise über die Leiterbahn 66 erfolgt. Bei einem derartigen Ausführungsbeispiel ist somit der Heizstrang auch in den schmaleren umgebogenen Seitenwandungen des Fluidkanals ausgebildet. Selbstverständlich kann auch bei einem derartigen Ausführungsbeispiel die Kontaktierung über aus dieser umgebogenen Seitenwandung herausgebogene Kontaktfahnen erfolgen, in deren Bereich dann jeweils wieder ein Leiterbahnendabschnitt (66') endet.

In Figur 10b ist dieses Konzept dahingehend weitergeführt, dass die geschwächten Randbereiche der Wärmeverteilschicht 62 wesentlich größere Abmessungen haben, so dass durch entsprechendes zweifaches Umbiegen um 90° Seitenwandungen 96 und Deckwandungen 98, 100 ausgebildet werden, die dann gemeinsam zumindest abschnittsweise Umfangswandungen des Fluidraums 80 ausbilden. Bei einem derartigen Ausführungsbeispiel wäre dann lediglich eine Platine 14 mit einem erfindungsgemäßen Heizkreis 24, 26 ausgeführt. Bei diesem Ausführungsbeispiel wird durch die beschriebenen Umbiegungen der Umfang eines Fluidkanals zumindest abschnittsweise ausgebildet. Selbstverständlich ist es auch möglich, eine offene Struktur, beispielsweise durch Umbiegen von Seitenwandungen 96 auszubilden und dann die Deckwandung als besonderes Bauelement auszuführen. Wie vorstehend erläutert, können sich Leiterbahnabschnitte oder Leiterbahnendabschnitte auch in die umgebogenen Bereiche hinein erstrecken, um dann eine Kontaktierung mit sonstigen Bauelementen zu ermöglichen.

Die IMS-Platinen können auch mehrlagig ausgeführt werden, so dass jeweils durch Isolationsschichten getrennte, übereinanderliegende Leiterbahnschichten ausgebildet werden, die dann jeweils Teil eines Heizstranges/Heizkreises und/oder der Steuer- oder Leistungselektronik ausbilden. Dabei kann beispielsweise ein passives Sensorelement integriert sein, wobei eine Leiterbahnschicht zur Stromverteilung und die andere Leiterbahnschicht im Wesentlichen als Heizstrang ausgeführt sind. Prinzipiell können jedoch auch mehrere Schichten als Heizstrang ausgebildet sein, wobei die jeweilige Heizleistung durch Variation des Querschnittes, insbesondere der Leiterbahndicke d angepasst wird.

Prinzipiell kann der Fluidraum 80 bei derartigen Varianten auch einerseits von einer einlagigen Platine und andererseits von einer mehrlagigen Platine mit Heiz- oder Stromverteilungsfunktion begrenzt sein.

Offenbart sind eine Platine mit einem aus Leiterbahnen gebildeten Heizstrang und ein mit einer derartigen Platine ausgeführter Heizer.

### Bezugszeichenliste:

- 1: Fluidheizer
- 2: Gehäuse
- 4: Mittelteil
- 6: Deckel oben
- 8: Deckel unten
- 10: Fluidanschluss
- 12: Fluidanschluss
- 14: Platine
- 16: Niedervoltstecker
- 18: Hochvoltstecker
- 20: Druckausgleichselement
- 22: Elektronikraum
- 24: Heizkreis
- 26: Heizkreis
- 28: Außenraum
- 30: Dichtkontur
- 32: Gewindebohrung
- 34: Anschlussfahne
- 36: Anschlussfahne
- 38: Anschlussfahne
- 40: Anschlussfahne
- 42: Schaltelement
- 44: Schaltelement
- 46: Anschluss
- 48: Anschluss
- 50: Anschluss
- 52: Anschluss
- 53: Anschluss
- 54: elektronisches Bauelement
- 56: elektronisches Bauelement
- 58: Heizstrang
- 60: Heizstrang
- 62: Wärmeverteilschicht
- 64: Isolierschicht
- 66: Leiterbahn
- 66': Leiterbahnendabschnitt
- 68: Lötstopplack
- 70: Leiterbahnabschnitt
- 72: Leiterbahnabschnitt
- 74: Umlenkung
- 76: Dichtelement
- 78: Dichtelement
- 80: Fluidraum
- 82: Temperatursensor
- 84: Fluidführungselement
- 85: Freiraum
- 86: Bodenplatte
- 87: Freiraum
- 88: Vorsprung
- 90: Kanal
- 94: Querschnitt
- 96: Seitenwandung
- 98: Deckenwandung
- 100: Deckenwandung

## Patentansprüche

1. Platine mit zumindest einer Leiterbahn (66), **gekennzeichnet durch** zumindest einen Heizstrang (58, 60), der durch die mit einem subtraktiven Verfahren ausgeformte Leiterbahn (66) ausgebildet ist und der auf eine vorbestimmte Heizleistung zur Erwärmung eines Fluids ausgelegt ist und mit einer Wärmeverteilschicht (62) zur Wärmeübertragung auf das Fluid.

2. Platine nach Patentanspruch 1, mit einer Steuerschaltung und/oder einer Leistungselektronik, die mit dem Heizstrang (58, 60) in Wirkverbindung steht oder der eine weitere Leiterbahn zugeordnet ist.

3. Platine nach Patentanspruch 1 oder 2, wobei der Heizstrang (58, 60) durch Leiterbahnen (66) gebildet ist, deren Querschnitt, Länge und Material entsprechend des für die Heizleistung erforderlichen Heizwiderstandes ausgelegt ist.

4. Platine nach einem der vorhergehenden Patentansprüche, wobei benachbart zur Wärmeverteilschicht (62) ein Fluidführungselement (84) ausgebildet ist.

5. Platine nach einem der vorhergehenden Patentansprüche, wobei auf dieser mehrere Heizstränge (58, 60) ausgebildet sind.

6. Platine nach einem der vorhergehenden Patentansprüche, wobei diese mehrlagig ausgebildet ist, und wobei in jeder Lage zumindest ein Heizstrang (58, 60) und/oder eine die Steuerschaltung oder die Leistungselektronik ausbildende Schaltung vorgesehen sind/ist.

7. Platine nach einem der vorhergehenden Patentansprüche, wobei der Heizstrang (58, 60) durch zumindest eine mäanderförmig oder bifilar ausgebildete Leiterbahn (66) gebildet ist.

8. Platine nach einem der vorhergehenden Patentansprüche, wobei diese eine IMS-Platine (14, 14') ist.

9. Platine nach Patentanspruch 8, wobei Funktionselemente durch Umbiegen von Laschen oder Randabschnitten der Platine (14, 14') ausgebildet sind, wobei zumindest die Leiterbahn (66) oder ein Leiterbahnendabschnitt (66') zur Ausbildung einer Kontaktfahne oder eines Heizstrangs/Heizstrangabschnitts in den umgebogenen Bereich hineingeführt ist.

10. Heizer mit einem Heizelement, das ausgelegt ist, ein einen Fluidraum (80) durchströmendes oder in diesem aufgenommenes Fluid zu erwärmen, **gekennzeichnet durch** zumindest eine Platine (14) nach einem der vorhergehenden Patentansprüche.

11. Heizer nach Patentanspruch 10, wobei die Platine (14) den Fluidraum (80) abschnittsweise begrenzt.

## Claims

1. A printed circuit board having at least one conducting path (66), **characterized by** at least one heating line (58, 60) formed by the conducting path (66) shaped via a subtractive method and designed to have a predetermined heating power for heating a fluid and having a heat dispersion layer (62) for transferring heat to the fluid.

2. The printed circuit board according to patent claim 1, having a control circuit and/or power electronics which is in operative connection with the heating line (58, 60) or to which a further conducting path is assigned.

3. The printed circuit board according to patent claim 1 or 2, wherein the heating line (58, 60) is formed by conducting paths (66), the cross-section, length and material of which are designed according to the heating resistance required for the heating power.

4. The printed circuit board according to one of the preceding patent claims, wherein a fluid guiding element (84) is formed adjacent to the heat dispersion layer (62).

5. The printed circuit board according to one of the preceding patent claims, wherein a plurality of heating lines (58, 60) are formed thereon.

6. The printed circuit board according to one of the preceding patent claims, wherein the printed circuit board is formed in multiple layers and wherein at least one heating line (58, 60) and/or a circuit forming the control circuit or the power electronics are provided in each layer.

7. The printed circuit board according to one of the preceding patent claims, wherein the heating line (58, 60) is formed by at least one meander-shaped or bifilar conducting path (66).

8. The printed circuit board according to one of the preceding patent claims, wherein it is an IMS-printed circuit board (14, 14').

9. The printed circuit board according to patent claim 8, wherein functional elements are formed by bending tabs or edge portions of the printed circuit board (14, 14'), wherein at least the conducting path (66) or a conducting-path terminal portion (66') for forming a contact tab or a heating line/heating line portion is led into the bent region.

10. A heater comprising a heating element adapted to heat a fluid flowing through or contained in a fluid compartment (80), **characterized by** at least one printed circuit board (14) according to one of the preceding patent claims.

11. The heater according to patent claim 10, wherein the printed circuit board (14) bounds the fluid compartment (80) in sections.

## Revendications

1. Platine avec au moins une piste conductrice (66), **caractérisée par** au moins un circuit de chauffage (58, 60) qui est formé par la piste conductrice (66) façonnée avec un procédé soustractif et qui est sur une puissance de chauffage prédéterminée pour le chauffage d'un fluide et avec une couche de répartition de chaleur (62) pour la transmission de chaleur au fluide.

2. Platine selon la revendication 1 avec un circuit de commande et/ou une électronique de puissance qui est en liaison active avec le circuit de chauffage (58, 60) ou à laquelle est associée une autre piste conductrice.

3. Platine selon la revendication 1 ou 2, dans laquelle le circuit de chauffage (58, 60) est formé par des pistes conductrices (66), dont la section transversale, la longueur et le matériau sont conçus selon la résistance de chauffage nécessaire à la puissance de chauffage.

4. Platine selon l'une quelconque des revendications précédentes, dans laquelle un élément de guidage de fluide (84) est formé de manière contiguë à la couche de répartition de chaleur (62).

5. Platine selon l'une quelconque des revendications précédentes, dans laquelle plusieurs circuits de chauffage (58, 60) sont formés sur celle-ci.

6. Platine selon l'une quelconque des revendications précédentes, dans laquelle celle-ci est formée en plusieurs couches, et dans laquelle dans chaque couche, au moins un circuit de chauffage (58, 60) et/ou un circuit formant le circuit de commande ou l'électronique de puissance est/sont prévu(s).

7. Platine selon l'une quelconque des revendications précédentes, dans laquelle le circuit de chauffage (58, 60) est formé par au moins une piste conductrice (66) formée en méandre ou de manière bifilaire.

8. Platine selon l'une quelconque des revendications précédentes, dans laquelle celle-ci est une platine IMS (14, 14').

9. Platine selon la revendication 8, dans laquelle des éléments fonctionnels sont formés par repliage de languettes ou de sections de bord de la platine (14, 14'), dans laquelle au moins la piste conductrice (66) ou une section d'extrémité de piste conductrice (66') est introduite pour la formation d'une lame de contact ou d'un circuit de chauffage/d'une section de circuit de chauffage dans la zone repliée.

10. Dispositif de chauffage avec un élément de chauffage qui est conçu afin de chauffer un fluide traversant un espace de fluide (80) ou reçu dans celui-ci, **caractérisé par** au moins une platine (14) selon l'une quelconque des revendications précédentes.

11. Dispositif de chauffage selon la revendication 10, dans lequel la platine (14) délimite par sections l'espace de fluide (80).
